Europäisches Patentamt

European Patent Office

Office européen des brevets

(11) Numéro de publication: **0 129 098**
**B1**

(12) **FASCICULE DE BREVET EUROPEEN**

(45) Date de publication du fascicule du brevet: **09.03.88**

(21) Numéro de dépôt: **84105919.9**

(22) Date de dépôt: **24.05.84**

(51) Int. Cl.⁴: **H 03 L 7/14, H 04 J 3/06**

(54) **Base de temps asservie.**

(30) Priorité: **27.05.83 FR 8308774**

(43) Date de publication de la demande:
**27.12.84 Bulletin 84/52**

(45) Mention de la délivrance du brevet:
**09.03.88 Bulletin 88/10**

(84) Etats contractants désignés:
**AT BE CH DE FR GB IT LI LU NL SE**

(56) Documents cités:
**EP-A-0 075 248**
**DE-A-2 527 971**
**DE-A-2 938 043**
**FR-A-1 444 235**
**FR-A-2 356 309**
**FR-A-2 390 856**

(73) Titulaire: **ALCATEL CIT**
**33, rue Emeriau**
**F-75015 Paris (FR)**

(72) Inventeur: **Lankar, André**
**195, rue du Faubourg Saint Denis**
**F-75010 Paris (FR)**
Inventeur: **Lalanne, Alain**
**2, rue J.H. Mansard**
**F-92600 Asnieres (FR)**

(74) Mandataire: **Weinmiller, Jürgen et al**
**Lennéstrasse 9 Postfach 24**
**D-8133 Feldafing (DE)**

Courier Press, Leamington Spa, England.

## Description

L'invention concerne les bases de temps asservies à une horloge externe notamment destinées à des autocommutateurs numériques et plus particulièrement les générateurs constituant ces bases de temps.

Dans les autocommutateurs on utilise classiquement une base de temps centralisée délivrant des signaux d'horloge et de synchronisation aux divers organes par l'intermédiaire de moyens de distribution.

Pour des raisons de sécurité et de fiabilité une telle base de temps est prévue redondante, elle comporte plusieurs générateurs identiques, le plus souvent trois.

Suivant une technique connue, on utilise dans les générateurs des oscillateurs à cristal, contrôlés d'une part en fréquence par application d'une tension et d'autre part en température. Ces contrôles sont obtenus de la manière suivante:

— le boîtier de l'oscillateur est thermostaté pour limiter l'influence de la température,

— la plage de fonctionnement de l'oscillateur est fixée par application d'un calibre de tension à l'entrée de contrôle,

— un contrôle de dérive est obtenu par superposition d'une tension d'asservissement et du calibre de tension,

— l'asservissement peut être obtenu par superposition d'un asservissement interne et d'un asservissement externe.

L'asservissement interne est obtenu à partir des signaux de sortie de l'oscillateur lui-même et des oscillateurs des autres générateurs de la base de temps, il est délivré en sortie d'un circuit logique de type majoritaire recevant en entrée les signaux des générateurs. L'asservissement externe est obtenu à partir d'une liaison délivrant une horloge externe. L'asservissement interne doit être prépondérant.

Une base de temps de ce type est décrite dans le brevet français n° 2.390.856 de la demanderesse.

Dans leur utilisation, les générateurs se synchronisent donc mutuellement, mais leurs alimentations et leurs moyens de distribution d'horloge vers les autres organes doivent être complètement indépendants. Pour chaque utilisation on dispose d'un module de distribution comportant une logique majoritaire qui reçoit les signaux des générateurs.

Un dispositif de distribution de signaux de ce type est décrit dans la demande de brevet EP—A—0 075 248 de la demanderesse.

La technique connue présente des inconvénients compte tenu des spécifications actuellement exigées pour les bases de temps des autocomutateurs, notamment dans le cas de réseaux synchronisés.

La fréquence des générateurs doit être fixée avec une précision accrue, être très stable, et l'asservissement à une horloge externe nécessite une correction très rapide de tout déphasage, et ceci en ne faisant varier la fréquence que dans des limites très étroites.

Le contrôle rapide du déphasage est nécessaire dans le cas où l'horloge externe peut subir elle-même un déphasage quelconque, par exemple en cas de coupure ou de basculement sur une horloge de secours.

Le but de l'invention est de réaliser une base de temps dont chaque générateur a une fréquence trè stable obtenue par un contrôle automatique du calibrage de l'oscillateur, et dont le déphasage par rapport à une horloge externe soit modifiable très rapidement.

L'invention a donc pour objet une base de temps asservie à une horloge externe et constituée de générateurs comportant chacun un oscillateur contrôlé en tension par un signal obtenu par comparaison d'un signal émanant de l'horloge externe avec un signal de sortie produit par la base de temps, lesdits générateurs étant interconnectés par des circuits majoritaires individuels qui reçoivent les signaux des différents générateurs et en déduisent chacun au moins un signal d'horloge majoritaire au profit du générateur qui lui est associé.

Selon une caractéristique de l'invention chaque générateur comporte un agencement d'asservissement essentiellement composé d'un comparateur différentiel de phase recevant à ses entrées le signal d'horloge externe et le signal de sortie de base de temps ci-dessus évoqués et alimentant en tension une entrée d'un circuit sommateur inséré en amont de l'entrée de commande de l'oscillateur du générateur considéré, ainsi que d'un dispositif de calibrage comprenant un détecteur de seuil connecté en dérivation en sortie du comparateur de phase et un circuit de réglage de tension de calibrage inséré entre le détecteur de seuil et une seconde entrée du circuit sommateur, ledit dispositif de calibrage comportant de plus un circuit de déclenchement de réglage de tension par le circuit de réglage de manière à permettre une correction rapide des déphasages. De plus un second comparateur différentiel reçoit le signal majoritaire du circuit majoritaire associé et un signal de sortie de l'oscillateur du générateur et ce second comparateur fournit un signal de sortie à une troisième entrée du circuit sommateur dudit générateur pour l'asservissement interne de la base de temps.

L'invention, ses caractéristiques et ses avantages sont précisés dans la description qui suit en relation avec les figures ci-dessous répertoriées.

— la figure 1 représente une base de temps formée de trois générateurs,

— la figure 2 est un schéma de principe d'un générateur,

— la figure 3 montre un dispositif de filtrage,

— la figure 4 montre un exemple de comparateur de phase différentiel,

— la figure 5 montre un sommateur à trois entrées,

— la figure 6 est le schéma d'un détecteur de seuil différentiel

— la figure 7 concerne une variante de réalisation destinée à compléter un générateur tel que présenté figure 2,

— la figure 8 montre une interface de synchronisation externe,

— la figure 9 est le schéma d'un circuit de supervision.

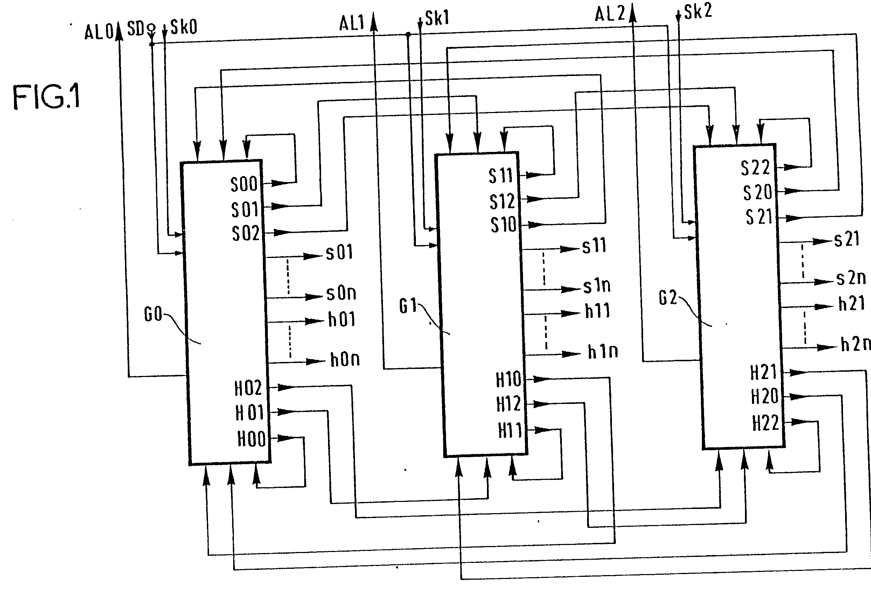

La base de temps présentée figure 1 comporte trois générateurs G0, G1, G2.

Chaque générateur délivre des signaux d'horloge H, h et des signaux de synchronisation S, s et il reçoit les signaux d'horloge et les signaux de synchronisation des deux autres générateurs. Chaque générateur délivre également un signal d'alarme AL, tel ALO, en cas d'anomalie; les signaux AL sont dirigés vers un dispositif d'alarme non représenté. Une horloge d'asservissement externe Sk est distribuée aux trois générateurs.

Les points d'entrée et de sortie des divers signaux d'horloge et de synchronisation sont représenté à la figure 1 avec des indices i et j indiquant respectivement le générateur d'origine et le générateur ou l'organe destinataire du signal ce sont:

— Hij: pour un signal d'horloge d'asservissement interne entre générateurs, tel HO1, qui est ici un signal symétrique de fréquence 4 MHz,

— hij: pour un signal d'horloge à destination d'un organe, tel h0n, il a même caractéristique que le précédent.

— Sij: pour un signal de synchronisation assurant l'asservissement interne entre générateurs, tel S00 qui a ici une féquence de 8 kHz, une durée de 244 ns,

— sij: pour un signal de synchronisation distribué vers des organes, tel s01 qui a mêmes caractéristiqes que le précédent,

— Skj: pour le signal d'asservissement externe destiné au générateur j, tel Sko qui a une fréquence de 8 kHz,

— SD: pour un signal associé aux signaux Skj indiquant un changement de signal de synchronisation comme précisé plus loin.

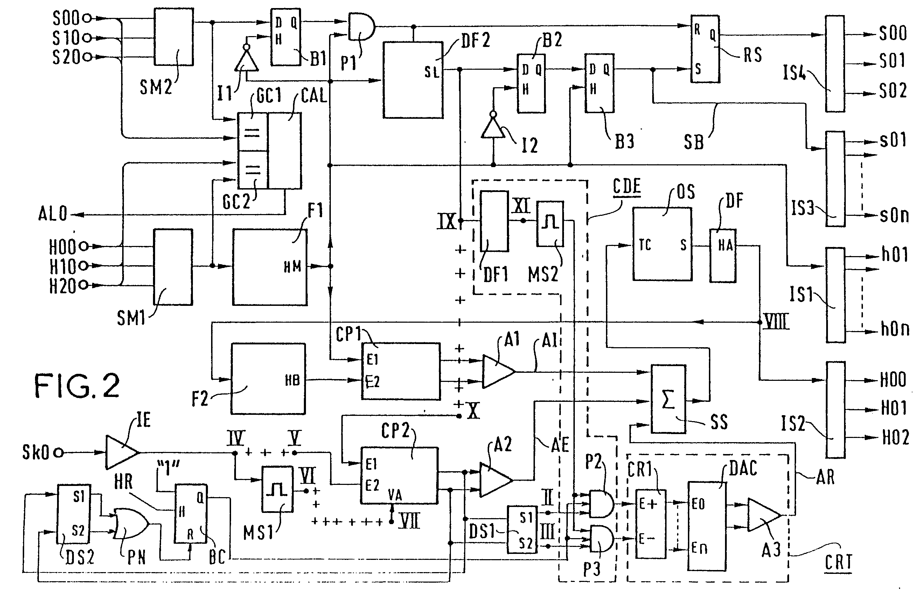

On a représenté à la figure 2 un mode de réalisation d'un générateur, soit ici GO. Comme on l'a vu, les trois générateurs sont identiques. On considérera ici comme établies les liaisons en tireté figurées entre les points IV et V, VI et VII, IX et X.

Les entrées d'horloge H00 à H20 émanant des trois générateurs G0, G1, G2 sont reliées à un circuit majoritaire SM1, dont la sortie est active lorsque deux au moins de ses entrées sont actives. Cette sortie est reliée à un circuit de filtrage F1 qui a pour rôle d'éliminer les fréquences parasites et de remettre en forme le signal. La sortie du circuit F1 délivre ainsi un signal d'horloge majoritaire HM symétrique de fréquence 4 MHz. Ce signal est délivré aux organes extérieurs sur les liaisons h01 à h0n par une interface de sortie IS1. Les parasites à éliminer apparaissent en particulier lorsque deux signaux en sortie du circuit majoritaire SM1 sont produits dans un même cycle, si l'un des générateurs est nettement décalé par rapport aux deux autres.

Un signal d'horloge interne HA est délivré par un oscillateur OS, contrôlé en tension, à travers un diviseur de fréquence DF. On utilise par exemple un oscillateur à 8 MHz et un diviseur par deux, ici, formé d'une bascule. Le signal HA est délivré sur les sorties H00 à H02 par une interface IS2.

L'entrée de commande en tension TC de l'oscillateur est reliée à la sortie d'un circuit sommateur SS piloté par des signaux d'asservissement interne AI, d'asservissement externe AE et de calibrage AR comme indiqué plus loin.

Le signal AI est délivré par un comparateur de phase différentiel CP1 suivi d'un amplificateur différentiel A1. Le comparateur CP1 reçoit en entrée le signal majoritaire HM et un signal interne HB en sortie d'un circuit de filtrage F2 qui reçoit le signal HA. Le circuit de filtrage F2 est identique au circuit F1, il a pour rôle de rendre symétrique la chaîne de comparaison, en particulier il égalise les temps de propagation des signaux HM et HB et évite l'influence des variations de température.

Les signaux de synchronisation s01 à s0n sont délivrés par une interface IS3 à partir d'un signal SB obtenu par division du signal HM. Le circuit de division comporte en série un diviseur de fréquence DF2 fournissant un signal de sortie de base de temps SL et deux bascules B2 et B3 de type D.

La bascule B2 est activée par le signal HM inversé par un inverseur I2 et la bascule B3 par le signal HM direct.

Les signaux de synchronisation S00 à S20 sont reçus à l'entrée d'un circuit majoritaire SM2 dont la sortie est reliée à l'entrée de donnée D d'une bascule B1 activée par le signal HM inversé par un inverseur I1. La sortie de la bascule B1 est reliée par une porte P1 activée par le signal HM, à une entrée de validation du diviseur DF2 et à l'entrée R d'une bascule RS. L'entrée S de cette bascule RS est reliée à la sortie de la bascule B3. La sortie de la bascule RS est reliée à une interface de sortie IS4 qui délivre les signaux de synchronisation S00 à S02. La bascule B1 a pour rôle de synchroniser le diviseur DF2 avec le signal majoritaire, et la bascule RS empêche la génération des signaux S00 à S02 en cas de disparition du signal HM.

L'asservissement externe par un signal d'asservissement tel Sko est obtenu par un comparateur de phase CP2 identique au comparateur CP1. Les entrées du comparateur CP2 sont reliées l'une à la sortie du diviseur DF2, l'autre à la sortie d'une interface IE recevant le signal d'asservissement Sko.

La sortie du comparateur est reliée à un amplificateur A2 qui délivre le signal d'asservissement AE.

Le comparateur CP2 doit être inhibé en cas de disparition du signal d'asservissement externe Sko pour permettre dans ce cas le fonctionnement autonome de la base de temps. Pour cela la sortie de l'interface IE est reliée à un monostable MS1 qui contrôle l'entrée de validation VA du comparateur. La durée des impulsions délivrées par le monostable MS1 est un peu supérieure à la période du signal d'asservissement externe Sko.

Le signal de calibrage AR est fourni par un dispositif de calibrage qui agit sur ce signal AR lorsque le déphasage indiqué par le comparateur CP2 dépasse un seuil déterminé.

En ce but le dispositif de calibrage comporte un détecteur de seuil différentiel DS1 relié aux sorties du comparateur CP2.

Le détecteur DS1 comporte deux sorties S1 et S2 reliées aux entrées d'un circuit de déclenchement de réglage de tension CDE qui contrôle un circuit de réglage de tension de calibrage CRT. La sortie S1 est activée lorsque le signal local est en retard sur le signal Sko avec un déphasage supérieur au seuil déterminé. La sortie S2 est activée lorsque le signal local est en avance avec un déphasage supérieur audit seuil. Les sorties S1 et S2 sont reliées respectivement aux entrées d'incrémentation E+ et de décrémentation E− d'un compteur CR1 à travers le circuit de déclenchement de réglage CDE composé des portes de contrôle P2 et P3, de type ET, qui sont validées par le signal de sortie SL divisé par un diviseur DF1 et appliqué à un monostable MS2. Dans le circuit de réglage de tension de calibrage, les sorties Q0 à Qn de poids 0 à n du compteur sont reliées à des entrées de même rang d'un convertisseur digital-analogique DAC. Le signal de calibrage AR est fourni par un amplificateur A3 relié à la sortie du convertisseur DAC.

Le signal de calibrage de l'oscillateur est ainsi mémorisé à l'aide du compteur CR1. Pour ajuster le signal de recalage on active périodiquement le monostable MS2, chaque impulsion du monostable permettant de faire progresser le compteur, en plus ou en moins, dans le cas où le déphasage dépasse le seuil.

Selon l'invention, il est également prévu un dispositif pour bloquer le compteur CR1 lorsque le déphasage indiqué par le comparateur CP2 est trop important.

Ceci a pour but de se prémunir contre une dérive importante du signal d'asservissement externe Sko non accompagnée de signalisation d'alarme.

Dans ce cas, il est intéressant de maintenir le calibrage constant sans tenir compte du signal d'asservissement externe Sko et de contrôler périodiquement la dérive pour débloquer à nouveau le compteur lorsque la dérive revient à une valeur acceptable.

Pour cela, les sorties du comparateur CP2 sont reliées à une second détecteur de seuil DS2, de même type que le premier, mais de seuil plus élève. Les portes P2 et P3 sont contrôlées par la sortie Q d'une bascule BC de type D.

Les sorties S1 et S2 du détecteur DS2 sont reliées à une porte PN qui contrôle la remise à zéro de la bascule BC.

L'entrée d'horloge H de la bascule BC est activée par un signal HR. Le signal HR a par exemple une période de 8 secondes et peut être obtenu par division du signal HM.

Ainsi lorsque la dérive atteint le seuil de déclenchement du détecteur DS2, le compteur CR1 est bloqué et le calibrage est maintenu constant. A chaque période du signal HR, les portes P2 et P3 sont à nouveau ouvertes et ne sont refermées que si la dérive atteint toujours le seuil de déclenchement du détecteur; sinon le fonctionnement normal du dispositif de calibrage automatique reprend.

Le signal d'activation du monostable MS2 est fourni par division du signal de sortie SL du diviseur DF2 à l'aide d'un diviseur de fréquence DF1. Par exemple pour une fréquence de 8 kHz en sortie du diviseur DF2, un diviseur DF1 à dix-neuf pas donne une période voisine de la minute pour le signal d'activation.

Le générateur G0 comporte également un circuit de signalisation d'alarme CAL qui envoie le signal d'alarme ALO lorsque l'un des signaux H00 à H20 ou S00 à S20 n'est plus en phase avec le signal majoritaire correspondant. Pour cela les signaux sont reçus par des groupes de comparateurs GC1 et GC2 formées par exemple de portes "OU EXCLUSIF". Un dispositif de ce type est décrit dans le brevet français N° 2.390.856 déjà cité.

On décrit ci-dessous à titre d'exemple un mode de réalisation des circuits constitutifs du générateur.

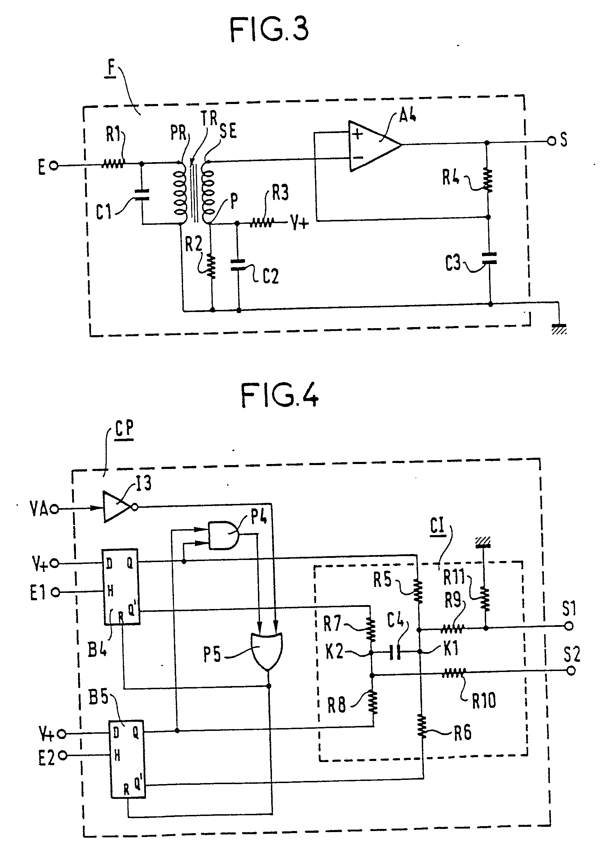

Les circuits de filtrage F1 ou F2 sont par exemple du type présenté figure 3, chaque circuit F comporte un transformateur TR et un amplificateur différentiel A4. Le primaire PR du transformateur TR à une borne reliée à la masse et l'autre reliée à une entrée de signaux E par une résistance R1. Le filtre est constitué par le primaire PR et un condensateur C1 couplé au primaire, et il est accordé sur la fréquence du signal d'horloge de 4 MHz. Le secondaire SE a une première borne reliée à l'entrée négative de l'amplificateur A4 et une seconde borne reliée à un point P dont la tension continue est fixée par un pont de résistances R2, R3 placé entre une tension de référence V+ et la masse. Le point P milieu du pont de résistances est relié à la masse par un condensateur C2.

La sortie de l'amplificateur A4 est reliée à la sortie S du circuit F, et couplée à l'entrée positive par une résistance R4.

Un condensateur C3 relie l'entrée positive de l'amplificateur A4 à la masse.

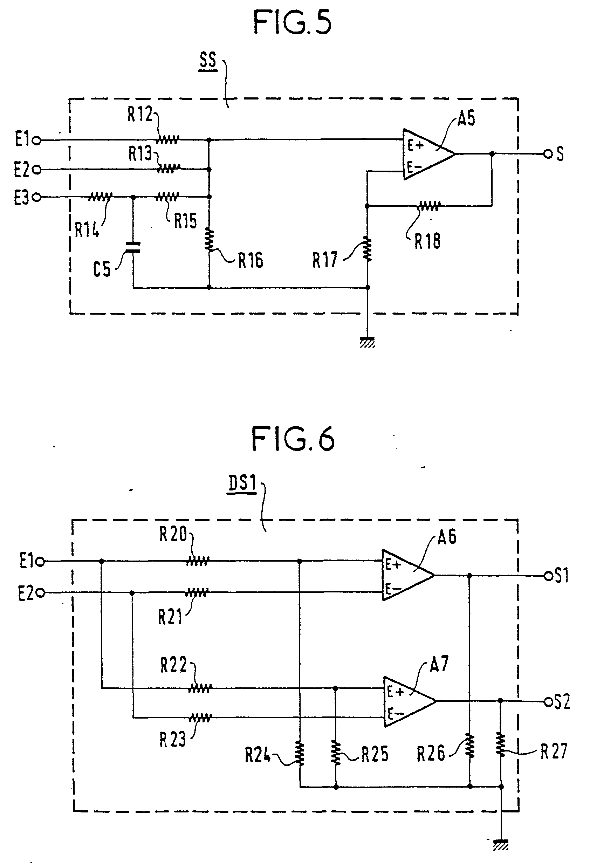

Les comparateurs de phase CP1, CP2 sont formés chacun de deux bascules d'entrée B4, B5 et d'un circuit d'intégration (figure 4). Les bascules B4 et B5 sont de type D et leur entrée de donnée D est reliée à la tension V+. L'entrée d'horloge H de la bascule B4 est reliée à l'entrée E1 du comparateur, l'entrée H de la bascule B5 est reliée à l'entrée E2 de ce même comparateur.

Les entrées de remise à zéro R des deux bascules sont commandées par une porte P5 de type OU en série avec une porte P4 de type ET dont les entrées sont reliées respectivement aux sorties Q des deux bascules B4, B5.

La porte P5 est également reliée par une entrée de contrôle à une entrée de signal de validation VA par un inverseur I3. Les bascules B4 et B5 sont ainsi bloquées en l'absence de signal de validation VA.

Le circuit d'intégration est formé de quatre résistances R5 à R8 et d'un condensateur C4 de bornes K1 et K2.

La résistance R5 est insérée entre la sortie Q de la bascule B4 et le point K1.

La résistance R6 est insérée entre la sortie Q' de la bascule B5 et le point K1.

La résistance R7 est insérée entre la sortie Q' de la bascule B4 et le point K2.

La résistance R8 est insérée entre la sortie Q de la bascule B5 et le point K2.

Le point K1 est relié à la sortie S1 du comparateur par une résistance R9, et le point K2 à la sortie S2 par une résistance R10. Une résistance R11 est reliée entre la sortie S1 et la masse.

Ainsi par exemple dans le cas où le signal apparaissant en E1 est en avance sur le signal en E2, le fonctionnement du comparateur est le suivant:

— en l'absence de signal en E1 et en E2 on a un état de repos,

— à l'apparition d'un signal en E1, il y a activation de la bascule B4 et charge du condensateur C4 le point K1 étant positif par rapport au point K2,

— à l'apparition d'un signal en E2, il y a activation de la bascule, remise à zéro des bascules B4 et B5, ainsi que recharge du condensateur C4,

— à la disparition du signal en E1, il y a réactivation de la bascule B5 et charge du condensateur C4 en sens inverse,

— à la disparition du signal en E2, il y a décharge de condensateur C4 et retour au repos.

Un dispositif sommateur SS est représenté à la figure 5. Il comporte un amplificateur différentiel A5 dont l'entrée positive E+ est reliée respectivement à l'entrée E1 du dispositif par une résistance R12 à l'entrée E2 par une résistance R13, à l'entrée E3 par deux résistances R14—R15 en série. Le point commun aux résistances R14 et R15 est relié à la masse par un condensateur C5, l'entrée positive E+ est également reliée à la masse par une résistance R16.

L'entrée négative E— est reliée d'une part à la masse par une résistance R17, d'autre part à la sortie S du dispositif par une résistance R18. Enfin la sortie de l'amplificateur A5 est reliée à la sortie S.

Ce dispositif effectue une sommation pondérée des signaux d'asservissement interne AI, d'asservissement externe AE, de calibrage AR. En particulier la stabilité requise de l'oscillateur nécessite que l'asservissement interne AI soit nettement prépondérant. Par exemple en cas de coupure ou de reprise du signal Sk, le déphasage à l'entrée du comparateur CP2 peut être quelconque. La modification des signaux AE et AR entraînera une variation de la fréquence de l'oscillateur pour rattraper le nouveau déphasage: cette variation de fréquence doit rester très limitée pour ne pas dégrader le signal d'horloge fourni par le générateur.

La figure 6 montre un mode de réalisation d'un détecteur de seuil DS1 comportant deux amplificateurs différentiels A6 et A7.

Les entrées E1 et E2 du détecteur sont reliées respectivement aux entrées E+ et E— des amplificateurs par des résistances R20 à R23. Les entrées E+ et E— sont couplées à la masse par des résistances R24 et R25. Les sorties des amplificateurs sont reliées d'une part à la masse par des résistances R26 et R27, et d'autre part aux sorties S1 et S2 du détecteur.

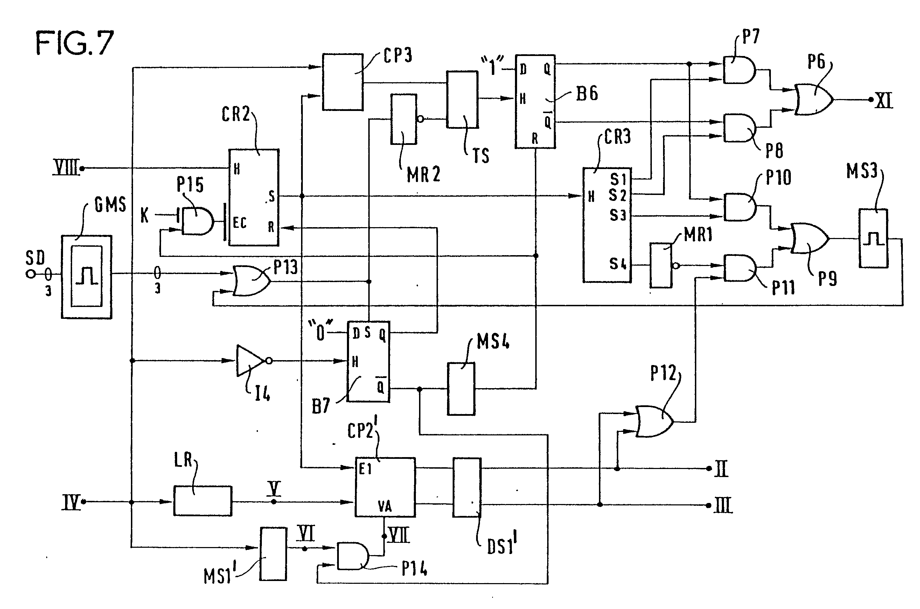

On va maintenant décrire l'application de l'invention à un réseau utilisant une liaison de synchronisation externe secourue. La figure 7 montre un dispositif associé à la base de temps représentée à la figure 2 pour tenir compte d'une telle liaison externe supplémentaire dite de signalisation et obtenir un recalage de phase et un recalibrage qui soient rapides.

On notera que les points II, III, IV, VIII et XI sont prévus raccordés aux points correspondants de la figure 2, que les liaisons IV—V, VI—VII et IX—X de la figure 2 sont coupées, une ligne à retard LR étant insérée entre les points IV et V, et une porte P14 entre les points VI et VII ainsi que le montre la figure 7.

Les éléments CP2', DS1' et MS1' mentionnés sur la figure 7 sont en fait les éléments CP2, DS1, MS1 qui sont présents sur la figure 2, et le diviseur DF1 de cette figure 2 est alors supprimé.

Le signal d'asservissement local à 8 kHz est fourni par un compteur programmé CR2 (figure 7) formant diviseur de fréquence, à partir du signal de fréquence 4 MHz fourni au point VIII par le diviseur DF (figure 2). La sortie du compteur CR2 attaque une entrée du comparateur CP2', un comparateur supplémentaire CP3 et un autre compteur CR3 à quatre sorties s1 à s4. La seconde entrée du comparateur CP3 est reliée en sortie de l'interface IE (figure 2), via le point IV.

Le compteur CR3 permet de sélectionner via le point XI deux périodes différentes d'émission d'impulsions par le monostable MS2 (figure 2) et deux périodes de remise en phase du compteur CR2, la sélection étant contrôlée par une bascule B6 de type D. L'entré du monostable MS2 est reliée via le point XI à la sortie d'une porte P6 de type OU attaquée par deux portes P7 et P8 du type ET.

La porte P7 est reliée à la sortie Q de la bascule B6 et à la sortie s1 du compteur, tandis que la porte P8 est reliée aux sorties respectives Q̄ et s2 des mêmes éléments.

De même, les sorties s3 et s4 attaquent un monostable MS3 par une porte P9 de type OU et des portes P10 et P11 de type ET. La porte P10 est contrôlée par la sortie Q de la bascule B6. La porte P11 est reliée à la sortie s4 du compteur CR3 par un monostable utilisé en retardateur MR1, et elle est contrôlée par les sorties du détecteur de seuil DS1' par l'intermédiaire d'une porte P12 de type OU.

Pour permettre la prise en charge des changements d'horloge du signal d'asservissement externe Sko sur la liaison distante, il est associé à celle-ci une liaison de signalisation SD reliée à un groupe de monostables GMS. La liaison SD comportera par exemple trois paires de fils indiquant respectivement:

— le basculement sur horloge de secours distante,

— le retour sur horloge normale distante,

— la coupure complète de l'horloge distante.

Chacune de ces liaisons contrôle un monostable du groupe GMS, et la sortie de chaque monostable est reliée à un circuit P13 de type OU également contrôlé par le monostable MS3. Le comparateur CP3 comporte une seule sortie qui est activée à partir d'une valeu déterminée de la valeur absolue du déphasage entre les signaux appliqués à ses deux entrées. La sortie du comparateur est reliée à un trigger TS qui pilote l'entrée H de la bascule B6. L'entrée D de la bascule est maintenue à l'état "1". Le trigger TS est contrôlé par un monostable utilisé en retardateur MR2, activé en sortie de la porte P13. Le comparateur CP3 est activé pour un seuil de déphasage nettement supérieur à celui du détecteur DS1, il est par exemple quatre fois plus élevé.

Une bascule B7 de type D est associée à la bascule B6 pour le contrôle des phases de fonctionnement du système.

La bascule B7 est activée par la sortie de la porte P13 reliée à son entrée S et remise à zéro sur le front descendant du signal Sko, son entrée D est maintenue à l'état "0" et l'entrée H est reliée au point IV par un inverseur I4.

La sortie Q de cette bascule est reliée à l'entrée de remise à zéro R du compteur CR2.

La sortie $\overline{Q}$ de la bascule B7 contrôle:

— l'entrée de validation du comparateur CP2' par une porte P14 de type ET également contrôlée par le monostable MS1',

— la remise à zéro de la bascule B6 par l'intermédiaire d'un monostable MS4,

— le chargement du compteur CR2 à une valeur K qui correspond à la mise en phase avec le front descendant du signal d'asservissement externe Sko: l'entrée Ec de chargement du compteur reçoit la valeur K câblée par un groupe de porte P15 de type ET contrôlées par la sortie du monostable MS4.

Enfin une ligne à retard LR relie le point IV à l'entrée du comparateur CP2.

Les différents cas de fonctionnement du générateur sont les suivants:

1/ En fonctionnement normal sans recalage, le détecteur DS1' n'étant pas activé, les bascules B6 et B7 restent au repos et le dispositif est sans action sur l'oscillateur.

2/ Si un léger décalage de phase agit sur le détecteur DS1' mais pas sur le comparateur CP3, la bascule B6 reste au repos et sa sortie $\overline{Q}$ autorise la commande à vitesse lente par la sortie s2 du compteur CR3 du monostable MS2 qui fait progresser le compteur CR1.

Lorsque la sortie s4 est activée, et après la temporisation produite par le monostable MR1, le monostable MS3 est activé et commande la bascule B7 dont la sortie Q passe à l'état et remet à zéro le compteur CR2. La sortie $\overline{Q}$ de la bascule B7 passe à l'état zéro et bloque le comparateur CP2' par la porte P14.

L'arrivée du front descendant du signal Sko remet à zéro la bascule B7 et active le comparateur CR2 ainsi que le monostable MS4 qui déclenche le chargement du compteur CR2 à la valeur K.

Le déphasage est annulé, et si la correction de tension appliquée à l'oscillateur par le compteur CR1 n'est pas suffisante, il se produire à nouveau une dérive et un cycle de recalage.

3/ Si le décalage est plus important et le comparateur CP3 est activé, le début du cycle est le même que dans le cas précédent.

L'impulsion émise par le monostable MS3 déclenche le trigger TS après le délai introduit par le monostable MR2. La bascule B6 est activée et sa sortie sélectionne le cycle de fonctionnement rapide, piloté par les sorties s1 et s3 du compteur CR3.

Après un cycle, la bascule B6 est remise au repos, et un nouveau cycle rapide n'interviendra que si le déphasage atteint à nouveau le seuil de déclenchement du comparateur CP3.

4/ En cas de basculement de l'horloge externe, l'un des monostables du groupe GMS est activé et active la bascule B7. Le compteur CR2 est donc remis à zéro et redémarre en phase avec le front descendant du signal Sko comme dans les cas précédents, et quel que soit le saut de phase provoqué par le basculement.

Le monostable MR2 est activé et introduit une temporisation permettant d'attendre la stabilisation du signal Sk après basculement, avant de tenir compte de l'indication du comparateur CP3. La suite du fonctionnement est celle de l'un des cas précédents suivant l'existence ou non d'une dérive par rapport à la nouvelle horloge externe.

5/ En cas de coupure totale du signal d'asservissement Sko, la bascule B7 activée par un monostable du groupe GMS, reste à l'état un. Le compteur CR2 et le comparateur CP2 sont inhibés. Le dispositif est bloqué et l'oscillateur reste calé à la position fixée avant la coupure. Les générateurs restent asservis en interne, et la base de temps fonctionne en mode autonome, c'est-à-dire avec le seul asservissement interne entre générateurs.

Il est également intéressant de pouvoir synchroniser la base de temps avec différents types de liens externes, la sélection étant faite par exemple à partir d'un pupitre d'opérateur.

Selon l'invention, il est prévu un dispositif d'interface recevant des liens externes de caractéristiques différentes, et qui distribue dans tous les cas à la base de temps, les signaux Sko à Sk2 et SD.

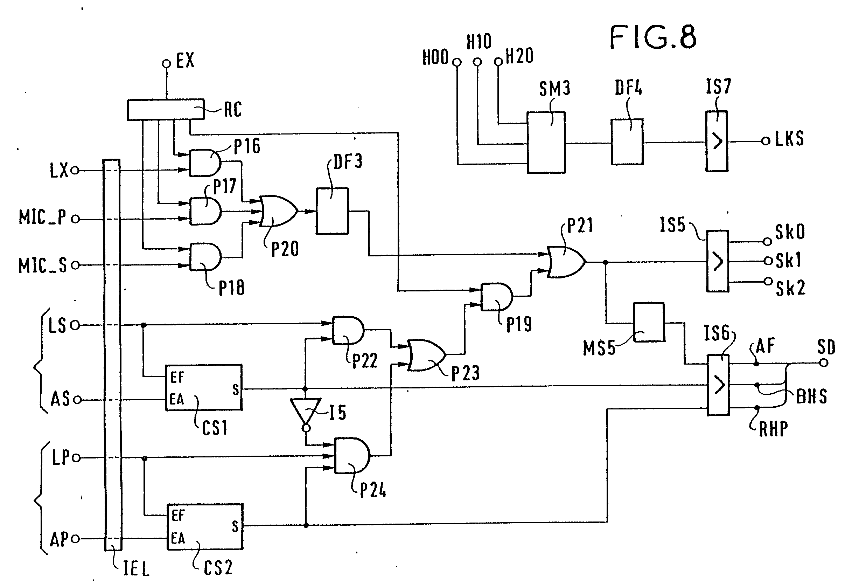

A titre d'exemple, on décrit ci-après (figure 8), une interface recevant trois sortes de signaux de synchronisation:

— Des signaux de fréquence 8 kHz reçus sur un -lien primaire LP et un lien secondaire LS. A chacun de ces liens est associé un lien d'alarme AP, AS dont le changement d'état indique un défaut du lien. Le lien primaire est prioritaire sur le lien secondaire.

— Des signaux de fréquence 2,048 MHz reçu sur des liaisons MIC aux normes européennes MIC—P, MIC—S.

— Un signal de fréquence 2,048 MHz reçu sur une liaison spécialisée LX, par exemple une horloge de haute précision émise par un réseau de synchronisation régional ou national.

Toutes ces liaisons sont raccordées à une interface d'entrée IEL; la sélection de la liaison à utiliser est effectuée par un registre RC dont les sorties contrôlent des portes d'accès, telles P16 pour la liaison LX, P17 pour la liaison MIC—P, P18 pour la liaison MIC—S, P19 pour les liaisons LS et LP. Pour les liaisons LX et MIC, un changement de liaison est réalisée par commande du registre.

Les sorties des portes P16 à P18 sont reliées par une porte "OU" P20 à un diviseur de fréquence DF3 qui fournit en sortie un signal de fréquence 8 kHz.

Le registre RC est chargé par son entrée EX, par exemple à partir d'un pupitre de commande ou à partir d'une interface d'ordinateur.

Les signaux d'asservissement Sko à Sk2 sont fournis par une interface de sortie IS5 dont l'entrée est reliée à la sortie d'une porte P21 de type OU reliée à la sortie du diviseur DF3 et à la sortie de la porte P19.

Les signaux de la liaison LS atteignent la porte P19 par une porte P22 de type ET contrôlée par un circuit de supervision CS1, et par une port P23, de type OU.

De même, les signaux de la liaison LP empruntent la porte P23 et une porte P24 de type ET, qui est contrôlée par un circuit de supervision CS2 identique à CS1 et par un inverseur I5 relié à la sortie du circuit CS1. La commande de la porte P24 par l'inverseur I5 assure les changements de liaison.

La liaison SD est obtenue en sortie d'une interface IS6 qui fournit:

— Le signal BHS de basculement sur horloge de secours en cas de passage à l'état zéro de la sortie du circuit CS1.

— Le signal RHP de retour sur horloge primaire en cas de passage à l'état zéro de la sortie du circuit CS2.

— Le signal de coupure AF correspondant à une absence de signal de fréquence est déterminé par un monostable MS5 activé par la porte P19 via la porte P21. La constante de temps du monostable MS5 est de 2 à 3 fois la période, par exemple 300 microsecondes.

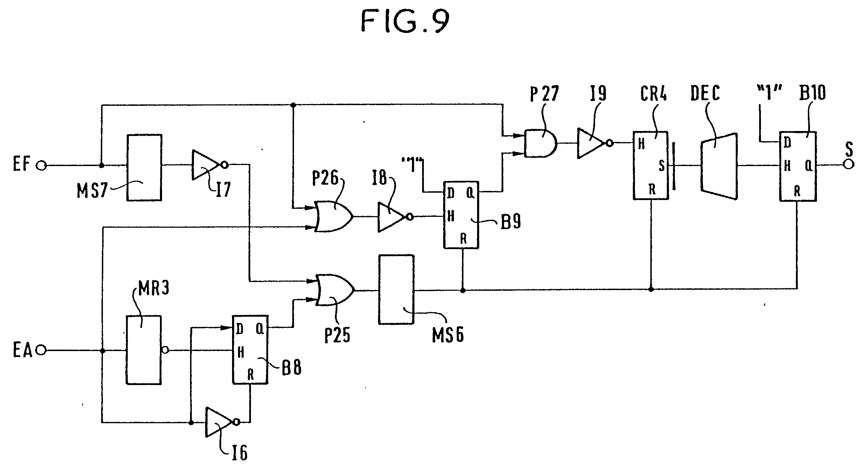

Les circuits de supervision CS1 et CS2 sont identiques (figure 9).

Le circuit de supervision CS1 a deux entrées EF et EA respectivement reliées l'une à la liaison de synchronisation LS ou LP, l'autre à la liaison d'alarme AS ou AP. Le rôle de ces circuits est de produire un signal de basculement (BHS ou BHP) en cas présence d'une alarme à l'entrée AS ou AP ou en cas d'absence du signal de fréquence LS ou LP.

L'entrée EA d'un circuit de supervision (figure 9) est reliée à un retardateur MR3 qui commande l'entrée d'horloge d'une bascule B8 de type D. L'entrée EA est également reliée à l'entrée D de la bascule et à un inverseur I6 qui contrôle l'entrée R de remise à zéro. La sortie Q de la bascule suit donc l'état de l'entrée EA sauf dans le cas de signaux de durée inférieure à la constante de temps du retardateur, qui sont considérés comme parasites et éliminés.

La bascule B8 commande un monostable MS6 à travers une porte P25 de type OU. Le monostable MS6 a pour rôle de maintenir une commande de basculement stable même si le signal d'entrée EA oscille ou est instable.

L'entrée EF est reliée à un monostable MS7 qui contrôle la porte P25 par un inverseur I7. Le monostable MS7 est maintenu activé par le signal présent à l'entrée EF, en cas de disparition de ce signal, il revient au repos et active le monostable MS6.

L'entrée EF est également reliée à une porte P26 de type OU et à une porte P27 de type ET. La porte P26 commande l'entrée d'horloge d'une bascule B9 par un inverseur I8. La porte P27 commande l'entrée d'horloge d'un compteur CR4 via un inverseur I9.

La sortie Q de la bascule B9 contrôle la porte P27. La sortie du compteur CR4 est reliée à un décodeur DEC. La sortie du décodeur DEC qui correspond ici au pas huit du compteur CR4 commande l'entrée d'horloge d'une bascule B10 dont la sortie Q est reliée à la sortie S du circuit CS1. La sortie du monostable MS6 commande l'entrée R de mise à zéro des bascules B9 et B10 et du compteur CR4. Enfin la porte P26 est également contrôlée par l'entrée EA.

Le fonctionnement des circuits de supervision CS1, CS2 est le suivant:

— Comme il a été dit ci-dessus, en cas de signal d'alarme AS ou AP apparaissant à l'une des entrées EA ou en cas de coupure des signaux de fréquence LP ou LS à l'une des entrées EF, le monostable MS 6 correspondant est activé et il met à zéro la bascule B10 et donc la sortie S du circuit qui le comporte.

— S'il y a eu alarme, à la disparition du signal d'alarme AS ou AP à l'entrée EA concernée débloque la porte P26 correspondante la bascule B8 correspondante est remise à zéro et le monostable MS6 correspondant est désactivé. La sortie S du circuit de supervision concerné sera réactivée après comptage de huit impulsions par l'intermédiaire du compteur CR4 et du décodeur DEC de ce circuit. Ce comptage donne une meilleure sécurité de reprise de la synchronisation externe.

— S'il y a eu coupure du signal de fréquence sans signalisation d'alarme, la reprise s'effectue dans les mêmes conditions après huit impulsions.

Dans le cas d'un défaut sur les liaisons MIC—P, MIC—S, LX, le fonctionnement sera le suivant:

— La disparition du signal de synchronisation provoquera le basculement du monostable MS5 et la génération du signal SD.

— La sélection d'une autre liaison sera faite par commande du registre RC soit à partir d'un pupitre d'opérateur, soit automatiquement si le registre est commandé par un ordinateur.

Enfin, la base de temps décrite est également adaptée au cas ou il est demandé une possibilité de synchronisation avec retour, la base de temps devant retransmettre sur une liaison LKS vers un centre distant un signal de contrôle de même fréquence que le signal de synchronisation qu'elle reçoit.

Dans l'example décrit, le retour correspondant à la liaison LX est réalisé par un circuit majoritaire SM3 recevant les signaux d'horloge H00, H10, H20 qu'il transmet à un diviseur de fréquence DF4. La sortie du diviseur DF4 est reliée à la liaison LKS par une interface de sortie IS7.

**Revendications**

1. Base de temps asservie à une horloge externe et constituée de générateurs (G) interconnectés par des circuits majoritaires individuels (SM) qui reçoivent les signaux de sortie des différents générateurs et en déduisent chacun au moins un signal d'horloge majoritaire (HM) au profit du générateur associé qui comporte un oscillateur (OS) contrôle en tension par un signal obtenu par comparaison d'un signal d'asservissement externe (Sk) émanant de l'horloge externe et d'un signal de sortie (SL) de la base de temps, cette dernière étant caractérisée en ce que chaque générateur comporte:
— un comparateur différentiel de phase (CP2) recevant à ses entrées le signal d'asservissement externe et le signal de sortie de base de temps ci-dessus évoqués et alimentant en tension une entrée d'un circuit sommateur (SS) inséré en amont de l'entrée de commande de l'oscillateur (OS) du générateur considéré;
— un dispositif de calibrage comprenant un détecteur de seuil (DS1) connecté en dérivation en sortie du comparateur de phase (CP2) et un circuit de réglage de tension de calibrage (CRT) inséré entre le détecteur de seuil (DS1) et une seconde entrée du circuit sommateur (SS), ledit dispositif de calibrage comportant de plus un circuit de déclenchement (CDE) de réglage de tension qui contrôle le circuit de réglage (CRT) auquel il est relié de manière à permettre une correction rapide des déphasages;
— un second comparateur différentiel (CP1) recevant à ses entrées ledit signal d'horloge majoritaire (HM) et un signal de sortie (HB) issu de l'oscillateur (OS) du générateur considéré et alimentant par sa sortie une troisième entrée du circuit sommateur (SS) de ce générateur, pour l'asservissement interne à la base de temps.

2. Base de temps selon la revendication 1, à circuit de réglage de tension de calibrage (CRT) composé d'un compteur (CR1) actionné par un détecteur de seuil (DS1) et connecté aux entrées d'un convertisseur numérique-analogique (DAC) dont la sortie est reliée à ladite seconde entrée du circuit sommateur (SS) du générateur considéré, pour assurer la mémorisation temporaire de la tension de calibrage, caractérisé en ce que le circuit de déclenchement (CDE) de chaque générateur comporte un diviseur (DF1) recevant au moins un signal issu de l'oscillateur (OS) du générateur considéré et deux portes de contrôle (P2 et P3) insérées entre les sorties du détecteur de seuil (DS1) et les entrées du compteur (CR1) et contrôlées par un monostable (MS2) placé en sortie du diviseur (DF1) pour le déclenchement cyclique des réglages.

3. Base de temps selon la revendication 1, caractérisé en ce que le comparateur de phase (CP2) recevant dans chaque générateur le signal d'asservissement externe (Sk) et un signal (SL) de sortie de base de temps dans chaque générateur est relié par son entrée de signal de sortie de base de temps à la sortie d'un second diviseur (DF2) relié en sortie d'un circuit majoritaire (SM1) fournissant le signal d'horloge majoritaire (HM) dans le générateur considéré.

4. Base de temps selon la revendication 1, caractérisée en ce que le dispositif de calibrage d'un générateur comporte aussi un compteur programmé (CR2) fonctionnement en diviseur dont l'entrée d'horloge est reliée à l'oscillateur (OS) du générateur considéré et dont la sortie fournit le signal (SL) de sortie de base de temps au comparateur de phase (CP2) recevant dans chaque générateur le signal d'asservissement externe (Sk) de manière que le dépassement d'un seuil de déphasage prédéteminé provoque la remise en marche du compteur à partir de la valeur programmée donnant un déphasage nul.

5. Base de temps selon la revendication 4, asservie par l'intermédiaire d'une liaison fournissant le signal d'asservissement externe (Sk) et d'une liaison de signalisation (SD) apte à indiquer divers états caractéristiques de l'horloge externe fournissant le signal correspondant (Sk) par l'intermédiaire d'un groupe de monostables (GMS) caractérisée en ce qu'elle comporte de plus, dans chaque générateur:
— un comparateur supplémentaire (CP3) recevant à ses entrées le signal de sortie (SL) fourni par le compteur programmé (CR2) et le signal d'asservissement externe, et fournissant un signal de sortie à partir d'un seuil de déphasage supérieur à celui du détecteur de seuil (DS1)
— un trigger (TS) déclenché par le signal de sortie du comparateur supplémentaire auquel il est relié par une entrée et contrôlé par tout mono-stable (GNS) en sortie duquel il est relié via un circuit (P13) de type OU et un monostable retardateur (MR2)
— un monostable de déclenchement d'impulsions de réglage (MS2) relié par sa sortie en entrée de deux portes de contrôle (P2, P3) insérées entre les sorties du détecteur de seuil (DS1) et les entrées du compteur (CR1),
— un compteur (CR3) de sélection de période d'emission d'impulsions de réglage relié en entrée du monostable de déclenchement (MS2) en parallèle avec le trigger (TS) via un ensemble de portes logiques (P6 à P12).

6. Base de temps selon la revendication 1, caractérisée par le fait que l'entrée du circuit de réglage (CRT) est contrôlée par un dispositif de contrôle de seuil (DS2, BC) relié à la sortie du comparateur (CP2), et bloquant l'entrée du circuit de réglage lorsque le seuil de déphasage dépasse une valeur déterminée et plus élevée que le seuil du détecteur (DS1) de manière à inhiber l'asservissement externe en cas de dérive du signal (Sko) supérieure à une valeur fixée.

7. Base de temps selon la revendication 6 caractérisée par le fait qu'elle comporte un dispositif d'interface recevant en entrée un lien de synchronisation primaire (LS, AS) et un lien de synchronisation secondaire (LP, AP), et fournissant en sortie le signal d'asservissement externe (Sk) et la liaison de signalisation (SD), ledit dispositif d'interface comportant:
— Un circuit de sélection (I5, P24, P22) du lien utilisé pour la synchronisation externe.
— Pour chaque lien, un circuit de supervision (CS1) mettant le lien hors service en cas de réception d'un signal d'alarme et en cas de coupure du signal de synchronisation reçu à l'entrée.

8. Base de temps suivant la revendication 1, caractérisée en ce qu'elle comporte une interface pouvant recevoir plusieurs liens de synchronisation externe de types différents et délivrant en sortie un signal d'asservissement externe (Sk) et la liaison de signalisation (SD), et étant constitué:
— de moyens de sélection de la liaison à utiliser.
— d'interfaces d'adaptation d'entrée (IEL) et de sortie (I5, IS6, IS7),
— d'au moins un diviseur de fréquence (DF3) pour ramener les différents signaux à la fréquence du signal d'asservissement externe (Sk).
— de moyens de signalisation de la coupure du signal de synchronisation (MS5, CS1, CS2).

## Patentansprüche

1. Einem äußeren Takt nachgeführte Zeitbasis, bestehend aus über individuelle Mehrheitsentscheidungskreise (SM) miteinander verbundenen Generatoren (G), wobei diese Kreise die Ausgangssignale der verschiedenen Generatoren zugeführt erhalten und daraus je mindestens ein Mehrheitstaktsignal (HM) zugunsten des zugeordneten Generators ableiten, und jeder Generator einen spannungsgesteuerten Oszillator (OS) enthält, der von einem Signal gesteuert wird, das durch Vergleich eines vom äußeren Takt stammenden äußeren Nachführungssignals (Sk) mit einem Ausgangssignal (SL) der Zeitbasis erhalten wird, dadurch gekennzeichnet, daß jeder Generator aufweist:
— einen Phasendifferentialkomparator (CP2), der an seinen Eingängen das erwähnte äußere Nachführungssignal und das erwähnte Ausgangssignal der Zeitbasis empfängt und eine Spannung an einen Eingang eines vor dem Steuereingang des Oszillators (OS) des betreffenden Generators eingefügten Summierkreises (SS) liefert,
— eine Eichvorrichtung mit einem Schwellendetektor (DS1), der parallel zum Ausgang des Phasenkomparators (CP2) angeschlossen ist, und mit einem Eichspannungsregelkreis (CRT), der zwischen dem Schwellendetektor (DS1) und einem zweiten Eingang des Summierkreises (SS) eingefügt ist, wobei die Eichvorrichtung außerdem einen Auslösekreis (CDE) für die Spannungsregelung aufweist, der den Eichspannungsregelkreis (CRT), mit dem er verbunden ist, so steuert, daß eine schnelle Korrektur der Phasenverschiebungen möglich wird,
— einen zweiten Differentialkomparator (CP1), dessen Eingänge das Mehrheitstaktsignal (HM) und ein vom Oszillator (OS) des betreffenden Generators stammmendes Ausgangssignal (HB) zugeführt erhalten und dessen Ausgang einen dritten Eingang des Summierkreises (SS) diese Generators zur internen Nachführung der Zeitbasis speist.

2. Zeitbasis nach Anspruch 1, mit einem Eichspannungsregelkreis (CRT), der aus einem Zähler (CR1) besteht, welcher von einem Schwellendetektor (DS1) betätigt wird und an die Eingänge eines Digital-Analog-Wandlers (DAC) angeschlossen ist, dessen Ausgang mit dem zweiten Eingang des Summierkreises (SS) des betreffenden Generators verbunden ist, um die vorübergehende Speicherung der Eichspannung zu bewirken, dadurch gekennzeichnet, daß der Auslösekreis (CDE) jedes Generators einen Teiler (DF1), der mindestens ein vom Oszillator (OS) des betreffenden Generators stammmendes Signal zugeführt erhält, und zwei Steuertore (P2 und P3) aufweist, die zwischen die Ausgänge des Schwellendetektors (DS1) und die Eingänge des Zählers (CR1) eingefügt sind und von einer monostabilen Kippstufe (MS2) gesteuert werden, die an den Ausgang des Teilers (DF1) zur zyklischen Auslösung der Regelvorgänge angeschlossen ist.

3. Zeitbasis nach Anspruch 1, dadurch gekennzeichnet, daß der Phasenkomparator (CP2), der in jedem Generator das äußere Nachführungssignal (Sk) und ein Ausgangssignal (SL) der Zeitbasis in jedem Generator zugeführt erhält, mit seinem das Ausgangssignal der Zeitbasis empfangenden Eingang an den Ausgang eines zweiten Teilers (DF2) angeschlossen ist, der am Ausgang eines Mehrheitsentscheidungskreises (SM1) liegt, welcher das Mehrheitsentscheidungstaktsignal (HM) in dem betreffenden Generator liefert.

4. Zeitbasis nach Anspruch 1, dadurch gekennzeichnet, daß die Eichvorrichtung eines Generators außerdem einen programmierten Zähler (CR2) aufweist, der als Teiler wirkt und dessen Takteingang an den Oszillator (OS) des betreffenden Generators angeschlossen ist, während sein Ausgang das Ausgangssignal (SL) der Zeitbasis an den Phasenkomparator (CP2) liefert, der in jedem Generator das äußere Nachführungssignal (Sk) zugeführt erhält, derart daß die Überschreitung einer vorgegebenen Phasenverschiebungsschwelle den Zählvorgang des Zählers ausgehend vom programmierten Wert entsprechend einer Phasenverschiebung Null auslöst.

5. Zeitbasis nach Anspruch 4, die über eine das äußere Nachführungssignal (Sk) liefernde Verbindung und eine Signalverbindung (SD) nachgeführt wird, die verschiedene charakteristische Zustände des äußeren Taktes angeben kann und das entsprechende Signal (Sk) über eine Gruppe von monostabilen Kippstufen (GMS) liefert, dadurch gekennzeichnet, daß außerdem in jedem Generator vorhanden sind:

— ein zusätzlicher Komparator (CP3) vorgesehen ist, dessen Eingänge das Ausgangssignal (SL) des programmierten Zählers (CR2) und das äußere Nachführungssignal zugeführt erhalten und dessen Ausgang ein Signal ausgehend von einer höheren Phasenverschiebungsschwelle als der Schwelle des Schwellendetektors (DS1) liefert,

— ein Trigger (TS), der vom Ausgangssignal des mit ihm über einen Eingang verbunden zusätzlichen Komparators ausgelöst und durch jede monostabile Kippstufe (GMS) gesteuert wird, mit deren Ausgang er über einen ODER-Kreis (P13) und eine monostabile Kippstufe (MR2) verbunden ist,

— eine monostabile Kippstufe (MS2) zur Auslösung von Regelimpulsen, die über ihren Ausgang an den Eingang von zwei Steuertoren (P2, P3) angeschlossen ist, die zwischen die Ausgänge des Schwellendetektors (DS1) und die Eingänge des Zählers (CR1) eingefügt sind,

— ein Selektionszähler (CR3) zum Auswählen der Regelimpulsendeperioden, der an den Eingang der monostabilen Auslösekippstufe (MS2) parallel zum Trigger (TS) über eine Gruppe von logischen Toren (P6 bis P12) angeschlossen ist.

6. Zeitbasis nach Anspruch 1, dadurch gekennzeichnet, daß der Eingang des Eichspannungsregelkreises (CRT) von einer Schwellensteuervorrichtung (DS2, BC) gesteuert wird, die an den Ausgang des Komparators (CP2) angeschlossen ist und den Eingang des Regelkreises blockiert, wenn die Phasenverschiebungsschwelle einen vorgegebenen Wert überschreitet, der höher liegt als die Detektorschwelle (DS1), so daß die äußere Nachführung unterbunden wird, wenn die Signalabweichung (Sko) größer als ein fester Wert ist.

7. Zeitbasis nach Anspruch 6, dadurch gekennzeichnet, daß sie eine Schnittstellenanordnung aufweist, die eingangsseitig eine Primärsynchronisationsverbindung (LS, AS) und eine Sekundärsynchronisationsverbindung (LP, AP) empfängt und ausgangsseitig das äußere Nachführungssignal (Sk) und die Signalverbindung (SD) liefert, wobei diese Schnittstellenanordnung aufweist:

— eine Selektionskreis (I5, P24, P22) zur Auswahl der für die äußere Synchronisation verwendeten Verbindung,

— für jede Verbindung einen Überwachungskreis (CS1), der die Verbindung außer Betrieb setzt, wenn ein Alarmsignal empfangen wurde und wenn das am Eingang empfangene Synchronisationssignal verschwindet.

8. Zeitbasis nach Anspruch 1, dadurch gekennzeichnet, daß sie eine Schnittstelle aufweist, die mehrere äußere Synchronisationsverbindungen unterschiedlicher Typen empfangen kann und ausgangsseitig ein äußeres Nachführungssignal (Sk) und die Signalverbindung (SD) liefert, sowie besteht aus:

— Mitteln zur Selektion der zu verwendenden Verbindung,

— einer Eingangsanpassungsschittstelle (IEL)

und einer Ausgangsanpassungsschnittstelle (I5, IS6, IS7),

— mindestens einem Frequenzteiler (DF3), um die verschiedenen Signale auf die Frequenz des äußeren Nachführungssignals (Sk) zu bringen,

— Mitteln zur Signalisierung der Synchronisationssignalunterbrechung (MS5, CS1, CS2).

**Claims**

1. A time base controlled by an external clock and consisting of generators (G) interconnected by individual majority circuits (SM) which receive output signals from the different generators and each derivating at least one majority clock signal (HM) for the associated generator, which comprises an oscillator (OS) voltage-controlled by a signal resulting from the comparison of an external follow-up signal (Sk) supplied by the external clock and an output signal (SL) supplied by the time base, the latter being characterized in that, each generator comprises:

— a differential phase comparator CP1) receiving at its inputs the external follow-up signal and the said signal supplied by the time base and delivering a voltage to the input of a summing circuit (SS) interconnected upstream the control input of the oscillator (OS) of the respective generator;

— a calibration system including a threshold detector (DS1) derived from the output of the phase comparator (CP2), and a calibration voltage adjustment circuit (CRT) interconnected between the threshold detector (DS1) and a second input of the summing circuit (SS), the said calibration system comprising in addition a voltage adjustment trigger circuit (CDE) which controls the calibration voltage adjustment circuit (CRT), to which it is connected, in such a manner as to correct phase differences very quickly;

— a second differential comparator (CP2) receiving at its inputs the said majority clock signal (HM) and an output signal (HB) supplied by the oscillator (OS) of the respective generator and feeding an output signal to a third input of the summing circuit (SS) of the generator, in order to ensure the internal follow-up of the time base.

2. A time base according to claim 1, wherein a calibration voltage adjustment circuit (CRT) comprises a counter (CR1) controlled by a threshold detector (DS1) and connected to the inputs of a digital-to-analog converter (DAC) having an output connected to said second input of the summing circuit (SS) of the respective generator, in order to ensure the temporary storage of the calibration voltage, characterized in that, the trigger circuit (CDE) of each generator comprises a divider (DF1) receiving at least one signal from the oscillator (OS) of the respective generator, and two control gates (P2 and P3) connected between the outputs of the threshold detector (DS1) and the inputs of the counter (CR1) and controlled by a monostable (MS2) connected to the output of the divider (DF1) for the cyclic triggering of the controls.

3. A time base according to claim 1, characterized in that, the phase comparator (CP2) receiving within each of the generators the external follow-up signal (Sk) and an output signal (SL) of the time base is connected by the input receiving the output signal of the time base to the output of a second divider (DF2) linked up with the output of a majority circuit (SM1) which delivers the majority clock signal (HM) into the respective generator.

4. A time base according to claim 1, characterized in that, the calibration system of a generator includes also a programmable counter (CR2) operating as a divider and having a clock input connected to the oscillator (OS) of the respective generator and the output of which delivering the output signal (SL) of the time base to the phase comparator (CP2), which receives within each generator the external follow-up signal (Sk), so as to cause the restarting of the counter from a programmed value which yields a null phase differnece, when a predetermined phase difference threshold is surpassed.

5. A time base according to claim 4, controlled through the intermediary of a link supplying the external follow-up signal (Sk) and by a signaling link (SD) adapted to indicate characteristic states of the external clock supplying the respective signal (Sk) through the intermediary of a group of monostables (GMS), characterized in that the time base further comprises:

— a supplementary comparator (CP3) receiving at its inputs the output signal (SL) delivered by the programmed counter (CR2) and the external follow-up signal, and supplying an output signal starting with a phase difference threshold greater than that of the threshold detector (DS1);

— a trigger circuit (TS) activated by the output signal of the supplementary comparators to which it is connected through an input and controlled by any monostable (GMS) to the output of which it is connected via a type OR circuit and a monostable delay circuit (MR2);

— an adjustment pulse trigger monostable (MS2) connected with its output to the input of two control gates (P2, P3) interconnected between the outputs of the threshold detector (DS1) and the inputs of the counter (CR1);

— an adjustment pulse transmission period select counter (CR3) connected to the input of the trigger monostable (MS2) in parallel with the trigger (TS) via a set of logic gates (P6 to P12).

6. A time base according to claim 1, characterized in that, the input of the control circuit (CRT) is controlled by a threshold control system (DS2, BC) connected to the output of the comparator (CP2), and inhibiting the input of the control circuit when the phase difference threshold exceeds a predetermined value which is higher than the threshold of the detector (DS1), whereby the external follow-up is inhibited if the drift of the signal (SkO) is greater than a fixed value.

7. A time base according to claim 6, characterized in that, it comprises an interface system receiving at the inputs a primary synchronization link (LP, AP) and a secondary synchronisation link (LS, AS) and delivering at the output the external follow-up signal (Sk) and the signaling link (SD), the interface system further comprising:

— a selection circuit (I5, P24, P22) for selecting the link used for external synchronization, and

— for each link a supervisory circuit (CS1) taking out of service the link in case of reception of an alarm signal and in case of cut-off of the synchronization signal received at the input.

8. A time base according to claim 1, characterized in that, it includes an interface adapted to connect with a plurality of external synchronization links of various types and delivering at the output an external follow-up signal (Sk) and the signaling link (SD), and consisting of:

— means for selecting the link to be used

— input matching interfaces (IEL) and output matching interfaces (I5, IS6, IS7)

— at least one frequency divider (DF3) for readjusting the various signals to the frequency of the external follow-up signal (Sk), and

— means for indicating cutting off of the synchronization signal (MS5, CS1, CS2).

FIG.1

0 129 098

FIG.2

# FIG.3

# FIG.4

# FIG.5

# FIG.6

4

FIG.7

FIG.8

FIG.9